# EUROPÄISCHE PATENTANMELDUNG

(11) **EP 4 188 050 A1**
(43) Veröffentlichungstag der Anmeldung: **31.05.2023**
(21) Anmeldenummer: 21211365.8
(22) Anmeldetag: 30.11.2021
(51) Int. Cl.: H05K 13/08

(54) **ERFASSEN UND AUSWERTEN VON PARAMETERWERTEN IN EINER ELEKTRONIKFERTIGUNGSLINIE**

(71) Anmelder: Siemens Aktiengesellschaft, 80333 München (DE)
(72) Erfinder: Blank, Rene, 12249 Berlin (DE); Borwieck, Carsten, 14052 Berlin (DE); Franke, Martin, 14089 Berlin (DE); Frühauf, Peter, 14612 Falkensee (DE); Heimann, Matthias, 14469 Potsdam (DE); Knofe, Rüdiger, 14513 Teltow (DE); Müller, Bernd, 16259 Falkenberg (DE); Nerreter, Stefan, 15754 Heidesee OT Blossin (DE); Wittreich, Ulrich, 16727 Velten (DE)
(74) Vertreter: Siemens Patent Attorneys

(57) **Zusammenfassung**

Die Erfindung ein Verfahren zum Erfassen und Auswerten von Parameterwerten in zumindest einer Elektronikfertigungslinie (200), wobei die Elektronikfertigungslinie (200) zum Fertigen von elektronischen Baugruppen (1,2) Vorrichtungen (20,30,40) aufweist. Um das Erfassen und insbesondere die Auswertung von Parameterwerten zu verbessern und zu vereinfachen, werden folgende Schritte vorgeschlagen:
- Empfangen von jeweils zumindest einem Parameterwert aus jeder der Vorrichtungen (20,30,40),
- Speichern der Parameterwerte in einem Datensatz (D), der jeweils einer definierten Anzahl von Bauelementträgern (PCB) und den daraus entstehenden Baugruppen (1,2) zugeordnet ist und
- Vergleichen der Parameterwerte des jeweiligen Datensatzes (D1,D2) mit zulässigen Bereichen für die Parameterwerte.

Die Erfindung betrifft weiterhin ein Verfahren zum Fertigen von elektronischen Baugruppen (1,2), sowie ein System (100) zum Erfassen von Parameterwerten.

## Beschreibung

Die Erfindung betrifft ein Verfahren zum Erfassen und Auswerten von Parameterwerten zumindest einer Elektronikfertigungslinie. Ein derartiges Verfahren kommt beispielsweise in industriellen Elektronikfertigungen zum Einsatz und kann vorteilhaft zentral erfolgen. Des Weiteren betrifft die Erfindung ein Verfahren zum Fertigen von elektronischen Baugruppen, sowie ein System zum Erfassen von Parameterwerten.

Die Elektronikfertigungslinie ist dabei zur Fertigung von elektronischen Baugruppen ausgebildet und weist dabei eine Reihe von Vorrichtungen auf, u. a. eine Vorrichtung zum Aufbringen von Fügematerial, beispielsweise ein Schablonendrucker für Lot- und/oder Sinterpasten oder Fügematerialdispensautomaten. Die Vorrichtungen zum Aufbringen von Fügematerial sind dabei so ausgestaltet, dass auf einen Bauelementträger, beispielsweise ein PCB- oder Keramiksubstrat, ein entsprechendes Fügematerial aufgebracht wird, jeweils an die Stellen, an denen dann elektrische Bauelemente vorgesehen und schlussendlich gefügt werden. Weiterhin weist die Fertigungslinie eine Bestückvorrichtung auf, die zum Bestücken von elektronischen Bauelementen auf die mit Fügematerial versehenen Bauelementträger ausgebildet ist. Bei den Bestückvorrichtungen kann es sich dabei um Bestückautomaten für SMD-Bauteile und weitere Elektronikbauteile handeln. Die Fertigungslinie weist weiterhin eine Fügevorrichtung auf, die zum Fügen der elektronischen Bauelemente an die Bauelementträger ausgebildet ist. Derartige Fügevorrichtungen können beispielsweise Reflow-Öfen oder für THT-Bauteile Wellen- und/oder Selektivlötanalagen sein.

Der Erfindung liegt die Aufgabe zugrunde, das Erfassen und insbesondere die Auswertung von Parameterwerten zu verbessern und zu vereinfachen.

Diese Aufgabe wird durch ein Verfahren mit den im Anspruch 1 angegebenen Merkmalen gelöst. Das erfindungsgemäße Verfahren umfasst dabei folgende Schritte:
- Empfangen von jeweils zumindest einem Parameterwert aus jeder der Vorrichtungen und
- Speichern der Parameterwerte in einem Datensatz, der jeweils einer definierten Anzahl von Bauelementträgern und/oder den daraus entstehenden Baugruppen zugeordnet ist.

Es hat sich herausgestellt, dass das Zusammenfassen einer Auswahl von Parameterwerten aus der Fertigungslinie in einen einzigen Datensatz einen erheblichen Vorteil gegenüber dem Verbleib der Daten und der Auswertung in den jeweiligen Vorrichtungen aufweist. So können nicht nur die notwendigen Untersuchungen zentralisiert werden, sondern es können in der laufenden Fertigung Optimierungen durchgeführt werden, die bereits für die nächsten Baugruppen angewandt werden können. So können die Anzahl von Ausschuss reduziert und die Taktzeit erhöht werden. Des Weiteren kann so auch für Dokumentations- und Zertifizierungszwecke ein zentrales Datenmanagement erheblich vereinfacht werden.

Die Parameterwerte sind dabei die während der Fertigung tatsächlich auf die konkreten Bauelementträger angewandten Werte der Prozessparameter der einzelnen Vorrichtungen. So können als Parameter bzw. deren Parametwerte folgende beispielhafte Größen herangezogen werden, die wiederum mit Seriennummern(-bereichen) der prozessierten Bauelementträger verknüpft werden können:
- Durchlaufgeschwindigkeit der Bauelementträger,
- Anzahl der prozessierten Bauelementträger in der aktuellen Charge (z.B. seit letzter Umrüstung / Wartung / Fertigungspause),
- Wölbung der Bauteileträger,
- Fügematerialinformationen (Pastenart, -alter, -viskosität, Charge, ...)
- Fügematerialauftrag (Rakelrichtung, Dauer seit Reinigungsintervall)
- Anzahl der bestückten Bauelemente,
- Bestückkräfte als Extremwerte (max/min) oder dedizierte Bestückkräfte für ausgewählte, z. B. empfindliche Bauteile,
- Temperaturen / Temperaturverläufe in der Fügevorrichtung,
- Restsauerstoffgehalt, Atmosphäre in der Fügevorrichtung,
- sowie weitere für die jeweilige Baugruppe relevante Parameterwerte.

In einer weiteren Ausführungsform umfasst das Verfahren weiterhin den Schritt des Vergleichens der Parameterwerte des jeweiligen Datensatzes mit zulässigen Bereichen für die Parameterwerte. So kann nicht nur ein gut handhabbarer Datensatz erzeugt werden, sondern dieser auch mit entsprechenden Bereichen verglichen werden. Weiterhin können Parameterwerte aus mehreren Datensätzen hinsichtlich eines wegdriftens von Werten untersucht werden. Bleiben also bestimmte parameterwerte über einen längeren Zeitraum sehr beständig und driften nun ab einem bestimmten Zeitpunkt weg, befinden sich aber noch im zulässigen Bereich, so kann frühzeitig Handlungsbedarf erkannt werden.

In einer weiteren Ausführungsform umfasst die Fertigungslinie zumindest eine Bereitstellungsvorrichtung zum Bereitstellen der Bauelementträger, beispielsweise einen Einlaufstapler, sowie eine Sammelvorrichtung zum Sammeln der fertiggestellten elektronischen Baugruppen, zum Beispiel einen Auslaufstapler. Auch diese Vorrichtungen liefern Parameterwerte, die empfangen und im Datensatz abgespeichert werden können. In der Bereitstellungsvorrichtung kann beispielsweise eine Zählung der bereitgestellten Bauelementträger stattfinden und in der Sammelvorrichtung dementsprechend eine Zählung der fertiggestellten Baugruppen.

In einer weiteren Ausführungsform umfasst die Fertigungslinie zumindest eine Inspektionsvorrichtung. Das Verfahren umfasst dabei weiterhin den Schritt Speichern eines Inspektionsergebnisses der Inspektionsvorrichtung im Datensatz, wenn die Inspektion ohne Befund ist. Das heißt in anderen Worten, es kann eine boolesche Variable "Inspektion in Ordnung" bzw. "Inspektion nicht in Ordnung" vorgesehen sein, wobei wenn die Variable gesetzt ist, dokumentiert ist, dass die Inspektion ohne Befund war, d.h. die inspizierte Baugruppe den geforderten Qualitätsbedingungen entspricht. Dies ist datentechnisch effizient und dokumentiert für spätere Zwecke, dass die Inspektion ohne Befund war. Ergänzend oder alternativ kann, wenn die Inspektionsvorrichtung einen Befund detektiert, zumindest Teile der Rohdaten, die der Inspektion zugrunde liegen, also beispielsweise Bilder, mit im Datensatz speichern. Beispielsweise kann es sich um Rohdaten einer mangelhaft aufgebrachten Fügepaste, eine mangelhafte Fügestelle, ein fehlendes Bauteil, ... handeln. Dies hat den Vorteil, dass direkt mit den anderen Parametern, die vielleicht zu diesem Fehlerbild geführt haben, verknüpfte Daten existieren und so eine Befundung erheblich vereinfachen und diese einfach automatisierbar machen. Die Inspektionsvorrichtungen können dabei optische oder auf Röntgenbasierte sowie weitere Inspektionsvorrichtungen sein. Beispiels sind hier SPI (Solder Paste Inspection), Automated X-ray inspection (AXI), ....

In einer weiteren Ausführungsform wird das Empfangen das Speichern und/oder Vergleichen durch ein System durchgeführt, das außerhalb der Vorrichtungen, insbesondere außerhalb der Fertigungslinie, angeordnet ist. In anderen Worten wird ergänzend oder alternativ zu den in den Vorrichtung vorgesehenen Parameterwertüberwachungen außerhalb Fertigungslinie die Datenerfassung und -auswertung durchgeführt. Das Speichern kann hier ebenso außerhalb durchgeführt werden. Beispiele sind hier sogenannte EDGE-Boxen an der Anlage (nicht Teil der Anlage), Zentrale Erfassungssysteme in der Fertigung vor Ort oder sogar Cloudbasierte Systeme. Der Vorteil eines Empfangens und Auswertens außerhalb der Vorrichtungen und/oder der Fertigungslinie ist die bessere Vergleichbarkeit der Datensätze und die stark vereinfachte Auswertbarkeit.

In einer weiteren Ausführungsform wird eine Anpassung von Prozessparametern der Elektronikfertigungslinie ermittelt. Diese Anpassung der Prozessparameter wird insbesondere dann ermittelt, wenn zumindest einzelne Parameterwerte innerhalb eines Datensatzes außerhalb eines zulässigen Bereichs liegen.

In einer weiteren Ausführungsform umfasst das Ermitteln einer Anpassung von Prozessparametern zumindest ein Ermitteln einer Linientaktung. Die Linientaktung bzw. die Geschwindigkeit mit der die Bauteileträger abgearbeitet werden, kann verringert oder erhöht werden, wenn die entsprechenden Parameter außerhalb eines definierten Bereiches liegen. Ist beispielsweise ein Restsauerstoffgehalt zu hoch, so könnte die Taktung verringert werden, um eine steigende Tendenz des Restsauerstoffs umzukehren.

In einer weiteren Ausführungsform wird für jede Baugruppe ein Datensatz, insbesondere genau ein Datensatz für jede Baugruppe erstellt. Dies hat den Vorteil, dass für jede einzelne elektrische Baugruppe die entsprechenden Daten, die erfasst wurden, auch systematisch dokumentiert und dementsprechend zur Verfügung gestellt werden. Es ist denkbar, dass jede einzelne Baugruppe eine Seriennummer oder eine vergleichbare Identifikation aufweist, mit der der Datensatz dann verknüpft werden kann.

In einer weiteren Ausführungsform wird für gleichartige Baugruppen, insbesondere identische Baugruppen, ein gemeinsamer Datensatz erstellt. Es ist denkbar, dass in diesem Datensatz die Parameterwerte abgespeichert werden, die identisch sind und, falls Abweichungen auftreten, diese kenntlich gemacht werden und dementsprechend fortlaufend abgespeichert werden. Dies ist besonders effizient hinsichtlich der Datensatzgröße.

In einer weiteren Ausführungsform weisen die Datensätze eine Kombination aus zwei oder mehr der folgenden Parameter auf:
- Restsauerstoffkonzentration,
- Restkapazität in einer Sammelvorrichtung,
- Verwölbungsdaten der Bauelementträger,
- Dauer und/oder Anzahl von gefertigten Baugruppen seit letzter Wartung und/oder Reinigung der Vorrichtung zum Aufbringen des Fügematerials,
- Durchlaufgeschwindigkeit und/oder Linientaktung und
- Fügematerialvolumen und/oder -masse und
- Anzahl von ungeplanten Störungen, Unterbrechungen und/oder Stillständen im laufenden Betrieb.

In einer weiteren Ausführungsform werden Parameterwerte von zumindest zwei Elektronikfertigungslinien erfasst, die Varianten einer Baugruppe oder baugleiche Baugruppen fertigen. Die Parameterwerte können weiterhin abgespeichert und ausgewertet werden. Baugleich sind Baugruppen insbesondere dann, wenn das Layout der Baugruppe identisch ist und beispielsweise nur die Speichergröße (RAM / SSD / FLASH) ohne Notwendigkeit einer Anpassung des Layouts variiert wird. Wenn sich die Leistungsfähigkeit (z.B. bei Leistungselektronik) der Baugruppe unterscheidet, kann dies eine Variante einer Baugruppe darstellen, so können die Parameterwerte der Varianten im Datensatz abgelegt werden. Auch hier ist die übergreifende Erfassung von erheblichem Vorteil, da Baugruppenübergreifend Daten in strukturierter Form vorliegen und entsprechende Erkenntnisse gewonnen werden können.

Die Aufgabe wird weiterhin durch ein Verfahren zum Fertigen von elektronischen Baugruppen gelöst. Das Fertigen der elektronischen Baugruppe umfasst dabei die Fertigungsschritte Bereitstellen von Bauelementträgern, Aufbringen von Fügematerial, Bestücken von Bauelementen auf die Bauelementträger und Fügen der Bauelemente an die Bauelementträger. Für die Fertigungsschritte werden dabei Datensätze gemäß eines der oben beschriebenen erfindungsgemäßen Verfahren erfasst und ausgewertet. Dies hat den Vorteil, dass direkt mit Fertigung der Baugruppen Datensätze zur Verfügung stehen die hinsichtlich Qualität und Optimierung der Baugruppen dokumentiert und ausgewertet werden können.

In einer weiteren Ausführungsform wird beim Fertigen der Baugruppen jedem Bauelementträger und/oder jeder Baugruppe ein Datensatz eindeutig zugeordnet. Dies hat nicht nur den Vorteil, dass zur Qualitätsüberprüfung direkt nach der Fertigung ein einziger Datensatz für jede der Baugruppen existiert, sondern hat auch für die weitere Nachverfolgung den Vorteil, dass die Fertigungsdaten bzw. die relevanten Prozessparameter dokumentiert und nachvollziehbar sind. Gerade bei Tracinganwendungen ist dies ein erheblicher Vorteil.

Die Aufgabe wird weiterhin durch ein System zum Erfassen von Parameterwerten in zumindest einer Elektronikfertigungslinie gelöst. Das Erfassungssystem weist dabei zumindest eine Kommunikationsschnittstelle zum Empfangen von Parameterwerten auf. Die Kommunikationsschnittstelle kann dabei als industrielle Kommunikationsschnittstelle, beispielsweise Profinet, Profibus, WLAN oder andere drahtlose und/oder drahtgebundene Kommunikationsschnittstellen ausgebildet sein. Das Erfassungssystem weist weiterhin eine Auswerteeinrichtung auf, die von der Kommunikationsschnittstelle die Parameterwerte erhält und zum Zuordnen und Speichern der Parameterwerte zu einem Datensatz bzw. zum Speichern in einem Datensatz ausgebildet ist. Insbesondere kann die Auswerteeinheit so ausgestaltet sein, dass sie im Rahmen des erfindungsgemäßen Verfahrens Daten für die dauerhafte Speicherung im Datensatz auswählt oder diese verwirft, weil diese keine Relevanz für den Datensatz besitzen. Die Datensätze werden dabei jeweils für eine festgelegte Anzahl von Bauelementträgern bzw. Baugruppen angelegt und können dabei gleichartige bzw. identische Gruppen von Baugruppen zusammenfassen, es ist aber ebenso denkbar, dass für jede einzelne Baugruppe bzw. für jeden einzelnen Bauelementträger ein eigener Datensatz angelegt wird.

In einer weiteren Ausführungsform weist das System eine weitere Kommunikationsschnittstelle auf, die zur Kommunikation mit einem Multisensor-Messgerät ausgebildet ist. Das Multisensor-Messgerät ist zum Durchlaufen der Elektronikfertigungslinie ausgebildet und liefert dabei Messwerte von Parametern, wie sie auf die Elektronikbaugruppen bzw. auf die Bauelementträger einwirken. Die Auswerteeinrichtung ist dabei so ausgebildet, dass die Messwerte jeweils den entsprechenden Datensätzen zugeordnet werden können und in diesen abgespeichert werden können. So bieten die Datensätze nicht nur die Daten, die originär aus den Vorrichtungen stammen, sondern werden auch um Messwerte angereichert, die die tatsächlichen Verhältnisse in der Anlage widerspiegeln.

Im Folgenden wird die Erfindung anhand der in den Figuren dargestellten Ausführungsbeispiele näher beschrieben und erläutert. Es zeigen:
- FIG 1: eine schematische Elektronikfertigungslinie und
- FIG 2: ein System zum Erfassen von Parameterwerten.

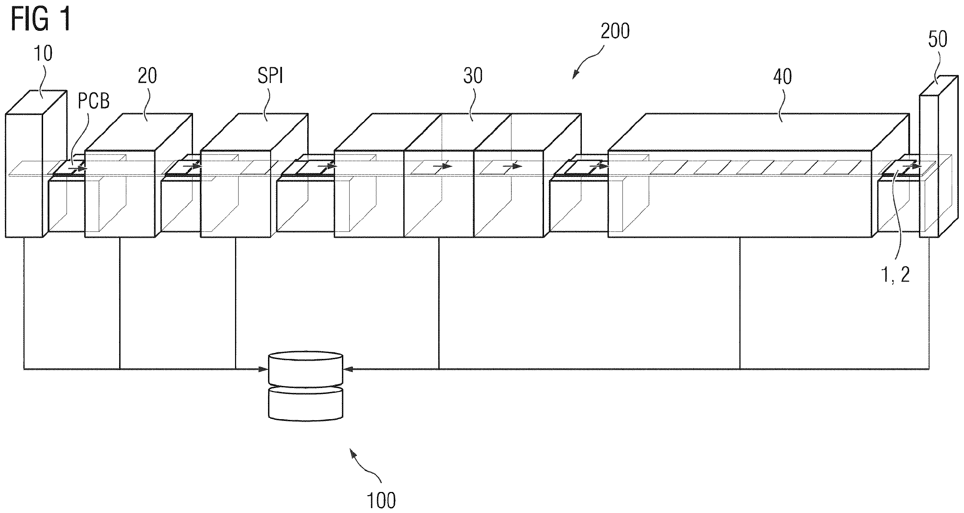

FIG 1 zeigt eine schematische Elektronikfertigungslinie 200, wie sie so oder in ähnlicher Form in großen Zahlen zum Einsatz kommen. Von links nach rechts weist die Elektronikfertigungslinie 200 eine Bereitstellungsvorrichtung 10 auf, die zum Bereitstellen von Bauelementträgern PCB, also beispielsweise Printed Circuit Boards oder andere Substrate, ausgebildet ist. Derartige Vorrichtungen können beispielsweise als Einlaufstapler ausgebildet sein. Weiterhin ist eine Vorrichtung 20 zum Aufbringen von Fügematerial gezeigt, die auf die Bauelementträger PCB Fügematerial aufbringt, dabei kann es sich beispielsweise um einen Schablonendrucker zum Aufbringen von Lotpaste handeln. Eine Inspektionsvorrichtung SPI ist im Anschluss an die Vorrichtung zum Aufbringen von Fügematerial angeordnet, in diesem Fall kann es sich um einer Solder Paste Inspection handeln, die beispielsweise auf Basis optischer Verfahren die Qualität des Fügematerialauftrags beurteilt. Darauffolgend ist eine Bestückvorrichtung 30 eingezeichnet, die elektrische Bauteile auf die nun mit Fügematerial versehenen Bauelementträger PCB bestückt. Im Anschluss an die Bestückvorrichtung 30 ist eine Fügevorrichtung 40 zu sehen, wobei es sich um einen Reflow-Ofen handeln kann, der die Fügematerialien aufschmilzt und so eine elektrische und mechanische Verbindung zwischen den elektrischen Bauteilen und den Bauelementträgern PCB erreicht. Die so entstehenden elektrischen Baugruppen 1,2 erreichen somit das Ende der Elektronikfertigungslinie, wofür eine Sammelvorrichtung 50 zur Verfügung steht. Bspw. als Auslaufstapler ausgebildet können die fertiggestellten elektronischen Baugruppen 1,2 gesammelt und gestapelt werden. Weiterhin ist ein System 100 zum Erfassen von Parameterwerten der Elektronikfertigungslinie 200 über Kommunikationsverbindungen jeweils mit den Vorrichtungen 10,...,50 verbunden. Das System 100 kann so von allen Vorrichtungen 10,...,50 entsprechende Parameterwerte empfangen, vorselektieren und/oder auswerten. Es ist dabei von besonderem Vorteil, dass ein einzelnes System 100 für mehrere Fertigungslinien zur Verfügung steht.

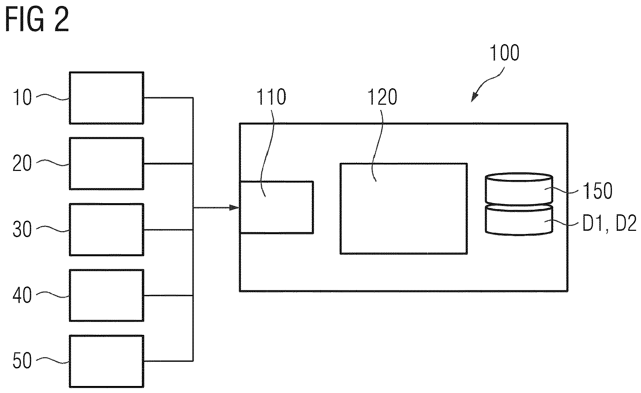

FIG 2 zeigt ein System 100 zum Erfassen von Parameterwerten, wie es in Figur 1 zum Einsatz kommt. Schematisch dargestellt sind nun die Vorrichtungen 10,...,50, die jeweils mit einer Kommunikationsschnittstelle 110 kommunizieren. Über diese Kommunikationsschnittstelle 110 können Parameterwerte oder andere Messwerte aus den Vorrichtungen direkt zur Verfügung gestellt werden. Eine Auswerteeinrichtung 120 ist derart ausgebildet, die empfangenen Parameterwerte jeweils zumindest einer Anzahl von Bauelementträgern bzw. den daraus entstehenden elektronischen Baugruppen zuzuordnen und dementsprechend in einem Datensatz D1, D2 abzuspeichern. Es ist weiterhin denkbar, dass die Auswerteeinrichtung 120 aus kontinuierlichen Strömen von Parameterwerten entsprechende Kennzahlen ermittelt, die dann wiederum im Datensatz D1, D2 gespeichert werden können. Die Werte sind dabei dementsprechend wie der gesamte Datensatz D1, D2 einer gewissen Anzahl von elektronischen Baugruppen 1, 2 zugeordnet und erlauben so eine direkte Rückverfolgbarkeit der Parameterwerte. Weiterhin ist eine Datenbank 150 vorgesehen, die zum Speichern der Datensätze D1, D2 ausgebildet ist. Eine derartige Datenbank kann sowohl lokal als auch serverbasiert realisiert werden.

Zusammenfassend betrifft die Erfindung Verfahren zum Erfassen und Auswerten von Parameterwerten in zumindest einer Elektronikfertigungslinie (200), wobei die Elektronikfertigungslinie (200) zum Fertigen von elektronischen Baugruppen (1,2) Vorrichtungen (20,30,40) aufweist. Um das Erfassen und insbesondere die Auswertung von Parameterwerten zu verbessern und zu vereinfachen, werden folgende Schritte vorgeschlagen:
- Empfangen von jeweils zumindest einem Parameterwert aus jeder der Vorrichtungen (20,30,40),
- Speichern der Parameterwerte in einem Datensatz (D), der jeweils einer definierten Anzahl von Bauelementträgern (PCB) und den daraus entstehenden Baugruppen (1,2) zugeordnet ist und
- Vergleichen der Parameterwerte des jeweiligen Datensatzes (D1,D2) mit zulässigen Bereichen für die Parameterwerte.

Die Erfindung betrifft weiterhin ein Verfahren zum Fertigen von elektronischen Baugruppen (1,2), sowie ein System (100) zum Erfassen von Parameterwerten.

### Bezugszeichen

- 10: Bereitstellungsvorrichtung
- 20: Vorrichtung zum Aufbringen von Fügematerial
- 30: Bestückvorrichtung
- 40: Fügevorrichtung
- 50: Sammelvorrichtung
- SPI: Inspektionsvorrichtung

- PCB: Bauelementträger
- 1,2: elektronische Baugruppen
- D1, D2: Datensatz der Parameterwerte
- 100: System zum Erfassen und Auswerten von Parameterwerten
- 110: Kommunikationsschnittstelle
- 120: Auswerteeinrichtung
- 150: Datenbank

- 200: Elektronikfertigungslinie

## Patentansprüche

1. Verfahren zum Erfassen und Auswerten von Parameterwerten in zumindest einer Elektronikfertigungslinie (200),
wobei die Elektronikfertigungslinie (200) zum Fertigen von elektronischen Baugruppen (1,2) ausgebildet ist und zumindest folgende Vorrichtungen (20,30,40) aufweist:
- eine Vorrichtung (20) zum Aufbringen von Fügematerial auf einen Bauelementträger (PCB),
- eine Bestückvorrichtung (30) zum Bestücken von elektronischen Bauelementen auf die Bauelementträger (PCB) und
- eine Fügevorrichtung (40) zum Fügen der elektronischen Bauelemente an die Bauelementträger (PCB),
wobei das Verfahren folgende Schritte umfasst:
- Empfangen von jeweils zumindest einem Parameterwert aus jeder der Vorrichtungen (20,30,40) und
- Speichern der Parameterwerte in einem Datensatz (D), der jeweils einer definierten Anzahl von Bauelementträgern (PCB) und den daraus entstehenden Baugruppen (1,2) zugeordnet ist.

2. Verfahren nach Anspruch 1, umfassend den Schritt:
- Vergleichen der Parameterwerte des jeweiligen Datensatzes (D1, D2) mit zulässigen Bereichen für die Parameterwerte.

3. Verfahren nach Anspruch 1 oder 2, wobei die Elektronikfertigungslinie (200) weiterhin folgende Vorrichtungen (10, 50) umfasst:
- eine Bereitstellungsvorrichtung (10) zum Bereitstellen der Bauelementträger (PCB) und
- eine Sammelvorrichtung (50) zum Sammeln der fertiggestellten elektronischen Baugruppen (1,2).

4. Verfahren nach Anspruch einem der vorhergehenden Ansprüche, wobei die Elektronikfertigungslinie (200) zumindest eine Inspektionsvorrichtung (SPI) umfasst, umfassend den Schritt:
- Speichern eines Inspektionsergebnisses der Inspektionsvorrichtung im Datensatz, wenn die Inspektion ohne Befund ist und/oder
- zumindest teilweises Speichern von Rohdaten, die der Inspektion zugrunde liegen im jeweiligen Datensatz (D1, D2), wenn die Inspektion einen Befund aufweist.

5. Verfahren nach einem der vorhergehenden Ansprüche, wobei das Empfangen, das Speichern und/oder das Vergleichen durch ein System (100) durchgeführt wird, das außerhalb der Vorrichtungen angeordnet ist.

6. Verfahren nach einem der vorhergehenden Ansprüche, umfassend den Schritt:
- Ermitteln einer Anpassung von Prozessparametern der Elektronikfertigungslinie (200), wenn zumindest einzelne Parameterwerte außerhalb des zulässigen Bereichs liegen.

7. Verfahren nach Anspruch 4, wobei das Ermitteln der Anpassung von Prozessparametern zumindest ein Ermitteln einer Linientaktung umfasst.

8. Verfahren nach einem der vorhergehenden Ansprüche, wobei für jede Baugruppe (1,2) ein Datensatz (D1,D2) erstellt wird.

9. Verfahren nach einem der Ansprüche 1 bis 6, wobei für gleichartige Baugruppen (1,2) jeweils ein gemeinsamer Datensatz (D1,D2) erstellt wird.

10. Verfahren nach einem der vorhergehenden Ansprüche, wobei die Datensätze (D1,D2) eine Kombination aus zwei oder mehr der folgenden Parameter umfassen:
- Restsauerstoffkonzentration,
- Restkapazität in einer Sammelvorrichtung (50),
- Verwölbungsdaten der Bauelementträger (PCB),
- Dauer und/oder Anzahl von gefertigten Baugruppen seit letzter Wartung und/oder Reinigung der Vorrichtung zum Aufbringen des Fügematerials,
- Durchlaufgeschwindigkeit und/oder Linientaktung und
- Fügematerialvolumen und/oder -masse und
- Anzahl von ungeplanten Störungen, Unterbrechungen und/oder Stillständen im laufenden Betrieb.

11. Verfahren nach einem der vorhergehenden Ansprüche, wobei Parameterwerte von zumindest zwei Elektronikfertigungslinien (200) empfangen werden, wobei die Elektronikfertigungslinien (200) Varianten einer Baugruppe (1,2) oder baugleiche Baugruppen (1,2) fertigen.

12. Verfahren zum Fertigen von elektronischen Baugruppen (1,2), umfassend die Fertigungsschritte:
- Bereitstellen von Bauelementträgern (PCB),
- Aufbringen von Fügematerial,
- Bestücken von Bauelementen auf die Bauelementträger (PCB) und
- Fügen der Bauelemente an die Bauelementträger (PCB),
wobei für die Fertigungsschritte Datensätze (D1,D2) gemäß einem Verfahren nach einem der vorhergehenden Ansprüche erfasst und ausgewertet werden.

13. Verfahren nach Anspruch 11, wobei beim Fertigen der Baugruppen (1,2) jedem Bauelementträger (PCB) und/oder jeder Baugruppe (1,2) ein Datensatz (D1,D2) eindeutig zugeordnet wird.

14. System (100) zum Erfassen von Parameterwerten in zumindest einer Elektronikfertigungslinie (200),
wobei das Erfassungssystem (100) zumindest eine Kommunikationsschnittstelle (110) zum Empfangen von Parameterwerten und eine Auswerteeinrichtung (120) aufweist, die zum Zuordnen der Parameterwerte einer festgelegten Anzahl von Bauelementträgern (PCB) in einem Datensatz (D1,D2) ausgebildet ist.

15. System nach Anspruch 13, aufweisend eine weitere Kommunikationsschnittstelle, die zur Kommunikation mit einem Multi-Sensor-Messgerät ausgebildet ist, wobei das Multi-Sensor-Messgerät zum Durchlaufen der Elektronikfertigungslinie (200) ausgebildet ist und Messwerte liefert, die einer Anzahl von elektrischen Baugruppen (1,2) zuordenbar sind,
wobei die Auswerteeinrichtung so ausgebildet ist, die Messwerte jeweils den entsprechenden Datensätzen (D1,D2) zuzuordnen.
